# EUROPEAN PATENT APPLICATION

(11) **EP 3 699 602 A1**
(43) Date of publication of application: **26.08.2020**
(21) Application number: 19158958.9
(22) Date of filing: 22.02.2019
(51) Int. Cl.: G01R 15/04

(54) **A VOLTAGE SENSOR FOR MEDIUM VOLTAGE OR HIGH VOLTAGE MEASUREMENTS**

(71) Applicant: ABB Schweiz AG, 5400 Baden (CH)
(72) Inventor: Javora, Radek, 664 62 Hrusovany u Brna (CZ); Pavlas, Marek, 683 54 Otnice (CZ)
(74) Representative: Maiwald Patent- und Rechtsanwaltsgesellschaft mbH

(57) **Abstract**

The present invention relates to a voltage sensor for medium voltage or high voltage measurements. The voltage sensor comprises a high voltage impedance (3), a low voltage impedance (5), and at least one part comprising semiconductor material. The high voltage impedance is configured to be electrically connected to a part of a system at high voltage potential. The high voltage impedance forms a first part of a voltage divider. The low voltage impedance is configured to be electrically connected to part of a system at ground potential. The low voltage impedance forms a second part of the voltage divider. The high voltage impedance is electrically connected to the low voltage impedance such that an axis is defined extending through the high voltage impedance and the low voltage impedance. The at least one part comprising semiconductor material surrounds at least one part of the axis.

## Description

### FIELD OF THE INVENTION

The present invention relates to a voltage sensor for medium voltage or high voltage measurements, for example in an air-insulated or gas-insulated switchgear for medium voltage or high voltage applications.

### BACKGROUND OF THE INVENTION

The use of voltage dividers in medium and/or high voltage environment is quite common in order to provide precise voltage measurement. The medium/high voltage environment is such that the voltage divider exhibits high electric field stress and intensity, especially in case of small a distance between medium/high voltage parts and ground potential, which may cause divider destruction or breakdown. In order to mitigate issues resulting from connection of the divider ends and/or to decrease the risk of breakdown due to pure adhesion of surrounding insulation material to the divider, electric field forming electrodes are sometimes used. These electrodes are made of conductive materials and bring electric field stress further from the divider and into a surrounding insulation material - see for example WO2014/023402A1. However, the electric field stress can still be high, and the same electric field stress can be brought to other parts of divider structure and may still keep electric stress on the divider surface. As higher and higher voltage levels are reached, it becomes increasingly difficult to reduce electric stress on the divider structure, especially due to small distances between high/medium voltage and the ground potential. This may result in higher scrap level or even make the design unreliable and susceptible to some quality issues.

There is a need to address these issues.

### SUMMARY OF THE INVENTION

Therefore, it would be advantageous to have an improved voltage sensor for medium voltages and high voltages.

The object of the present invention is solved with the subject matter of the independent claims, wherein further embodiments are incorporated in the dependent claims.

In a first aspect, there is provided a voltage sensor for medium voltage or high voltage measurements, the voltage sensor comprising:
- a high voltage impedance;
- a low voltage impedance; and
- at least one part comprising semiconductor material. The high voltage impedance is configured to be electrically connected to a part of a system at high voltage potential. The high voltage impedance forms a first part of a voltage divider. The low voltage impedance is configured to be electrically connected to part of a system at ground potential. The low voltage impedance forms a second part of the voltage divider. The high voltage impedance is electrically connected to the low voltage impedance such that an axis is defined extending through the high voltage impedance and the low voltage impedance. The at least one part comprising semiconductor material surrounds at least one part of the axis.

In an example, the at least one part comprising semiconductor material is configured to gradually reduce electric field stress in at least one direction along the axis toward the centre of the voltage divider.

In an example, the at least one part comprising semiconductor material comprises at least one length of semiconductor material. The at least one length of semiconductor material is wound around and spaced from the at least one part of the axis. At least a part of the at least one length of semiconductor material is wound in a spiral form extending along the axis.

In an example, a length of the at least one length of semiconductor material is wound around and spaced from a part of the axis in the vicinity of the first part of the voltage divider.

In an example, a length of the at least one length of semiconductor material is wound around and spaced from a part of the axis in the vicinity of the second part of the voltage divider.

In an example, a first length of the at least one length of semiconductor material is wound around and spaced from the axis in the vicinity of the first part of the voltage divider. Additionally, a second length of the at least one length of semiconductor material is wound around and spaced from the axis in the vicinity of the second part of the voltage divider.

In an example, at least one turn of the at least one length of semiconductor material is spaced from at least one adjacent turn of the at least one length of semiconductor material.

In an example, at least one turn of the at least one length of semiconductor material is spaced from and insulated from at least one adjacent turn of the at least one length of semiconductor material by an insulating material.

In an example, the at least one length of semiconductor material has a resistivity of at least 10 Ohm per metre.

In an example, the at least one length of semiconductor material is a semiconductor tape or semiconductor wire

In an example, the voltage sensor comprises at least one shielding electrode surrounding at least one part of the axis.

In an example, a shielding electrode of the at least one shielding electrode is in the vicinity of the first part of the voltage divider.

In an example, a shielding electrode of the at least one shielding electrode is in the vicinity of the second part of the voltage divider.

In an example, the shielding electrode of the at least one shielding electrode in the vicinity of the first part of the voltage divider comprises a part of the shielding electrode configured to be at high voltage potential. The shielding electrode comprises an axial dimension toward the centre of the voltage divider that is greater than an axial dimension of the shielding electrode toward the part of the system at high potential.

In an example, the shielding electrode of the at least one shielding electrode in the vicinity of the second part of the voltage divider comprises a part of the shielding electrode configured to be at ground potential. The shielding electrode comprises an axial dimension toward the centre of the voltage divider that is greater than an axial dimension of the shielding electrode toward the part of the system at ground potential.

In an example, a first shielding electrode of the at least one shielding electrode is in the vicinity of the first part of the voltage divider and a second shielding electrode of the at least one shielding electrode is in the vicinity of the second part of the voltage divider.

In an example, an end of the at least one shielding electrode toward the centre of the voltage divider has a radius of curvature of at least 0.1 mm.

In an example, a length of semiconductor material of the at least one length of semiconductor material is wound around the shielding electrode of the at least one shielding electrode in the vicinity of the first part of the voltage divider.

In an example, a length of semiconductor material of the at least one length of semiconductor material is wound around the shielding electrode of the at least one shielding electrode in the vicinity of the second part of the voltage divider.

In an example, a first length of semiconductor material of the at least one length of semiconductor material is wound around the first shielding electrode and a second length of semiconductor material of the at least one length of semiconductor material is wound around the second shielding electrode.

In an example, the voltage sensor comprises at least one insulating former surrounding at least one part of the axis. The at least one length of semiconductor material is wound around the at least one former.

In an example, a former of the at least one former is attached to the shielding electrode of the at least one shielding electrode that is in the vicinity of the first part of the voltage divider.

In an example, a former of the at least one former is attached to the shielding electrode of the at least one shielding electrode that is in the vicinity of the second part of the voltage divider.

In an example, a length of semiconductor of the at least one length of semiconductor is electrically connected to the shielding electrode that is in the vicinity of the first part of the voltage divider.

In an example, a length of semiconductor of the at least one length of semiconductor is electrically connected to the shielding electrode that is in the vicinity of the second part of the voltage divider.

In an example, a first former of the at least one former is in the vicinity of the first part of the voltage divider and a second former of the at least one former is in the vicinity of the second part of the voltage divider.

In an example, the voltage sensor comprises a first wire and a second wire. The first wire is configured to be electrically connected at a point between the high voltage impedance and the low voltage impedance. The second wire is configured to be electrically connected at a point between the low voltage impedance and the part of system at ground potential.

In a second aspect, there is provided a medium voltage or high voltage switchgear, comprising at least one voltage sensor according to the first aspect.

The above aspects and examples will become apparent from and be elucidated with reference to the embodiments described hereinafter.

### BRIEF DESCRIPTION OF THE DRAWINGS

Exemplary embodiments will be described in the following with reference to the following drawings:
Fig. 1 shows an example of a known voltage sensor;
Fig. 2 shows an example of a new voltage sensor;
Fig. 3 shows an example of a new voltage sensor;
Fig. 4 shows parts of an example of a new voltage sensor; and
Fig. 5 shows the electric stress level along the axis of different voltage sensors.

### DETAILED DESCRIPTION OF EMBODIMENTS

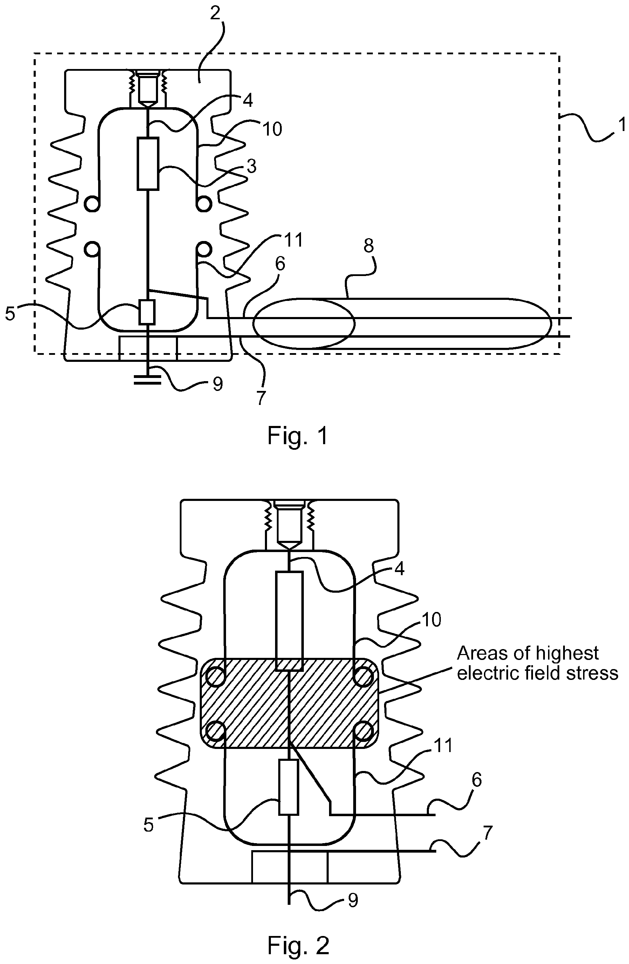

To set the scene for the new voltage sensor described here, an existing voltage sensor with a general voltage divider is first described. Fig. 1 shows a known voltage sensor having a general impedance divider. Insulating body 2 accommodates a high-voltage impedance 3 that is connected at one end to a high voltage by connection 4, and is connected at the other end to a low-voltage impedance 5. Both the high-voltage impedance 3 and low-voltage impedance (5) form a voltage divider with a given division ratio. The voltage divider is grounded through connection 9 and output wires 6 and 7 go through the cable 8, which is shielded in order to minimize effects of external field on low-voltage signal going through the wires 6 and 7. In order to reduce capacitive pickup from external voltage sources or fields, shielding electrodes are used. Fig. 1 shows upper-shielding electrode 10 which protects the high-voltage impedance 3 from external influences and lower-shielding electrode 11 which protects low-voltage impedance 5 from external influences. The shielding electrodes 10 and 11 at the same time also serve as an electric field forming electrodes, bringing electric field stress and intensity from connection 4 and low-voltage parts 5 to the areas between those electrodes, which is surrounded by insulation material. The voltage sensor is shown in an enclosure 1, that for example could be part of a medium voltage or high voltage switchgear.

Now, a new voltage sensor has been designed, with Figs. 2-4 relating to the new voltage sensor for medium and high voltage measurements. In an example, the voltage sensor comprises a high voltage impedance 3, a low voltage impedance 5, and at least one part comprising semiconductor material. The high voltage impedance is configured to be electrically connected to a part of a system at high voltage potential. The high voltage impedance forms a first part of a voltage divider. The low voltage impedance is configured to be electrically connected to part of a system at ground potential. The low voltage impedance forms a second part of the voltage divider. The high voltage impedance is electrically connected to the low voltage impedance such that an axis is defined extending through the high voltage impedance and the low voltage impedance. The at least one part comprising semiconductor material surrounds at least one part of the axis.

According to an example, the at least one part comprising semiconductor material is configured to gradually reduce electric field stress in at least one direction along the axis toward the centre of the voltage divider.

According to an example, the at least one part comprising semiconductor material comprises at least one length of semiconductor material 21. The at least one length of semiconductor material is wound around and spaced from the at least one part of the axis. At least a part of the at least one length of semiconductor material is wound in a spiral form extending along the axis.

According to an example, a length of the at least one length of semiconductor material is wound around and spaced from a part of the axis in the vicinity of the first part of the voltage divider. Additionally, or alternatively a length of the at least one length of semiconductor material is wound around and spaced from a part of the axis in the vicinity of the second part of the voltage divider.

According to an example, a first length of the at least one length of semiconductor material is wound around and spaced from the axis in the vicinity of the first part of the voltage divider and a second length of the at least one length of semiconductor material is wound around and spaced from the axis in the vicinity of the second part of the voltage divider.

According to an example, at least one turn of the at least one length of semiconductor material is spaced from at least one adjacent turn of the at least one length of semiconductor material.

According to an example, at least one turn of the at least one length of semiconductor material is spaced from and insulated from at least one adjacent turn of the at least one length of semiconductor material by an insulating material 20.

According to an example, the at least one length of semiconductor material has a resistivity of at least 10 Ohm per metre.

According to an example, the at least one length of semiconductor material is a semiconductor tape or semiconductor wire

According to an example, the voltage sensor comprises at least one shielding electrode 10, 11 surrounding at least one part of the axis.

According to an example, a shielding electrode 10 of the at least one shielding electrode is in the vicinity of the first part of the voltage divider. Additionally, or alternatively a shielding electrode 11 of the at least one shielding electrode is in the vicinity of the second part of the voltage divider.

According to an example, the shielding electrode 10 of the at least one shielding electrode in the vicinity of the first part of the voltage divider comprises a part of the shielding electrode configured to be at high voltage potential. This shielding electrode comprises an axial dimension toward the centre of the voltage divider that is greater than an axial dimension of the shielding electrode toward the part of the system at high potential. Additionally, or alternatively the shielding electrode 11 of the at least one shielding electrode in the vicinity of the second part of the voltage divider comprises a part of the shielding electrode configured to be at ground potential. This shielding electrode comprises an axial dimension toward the centre of the voltage divider that is greater than an axial dimension of the shielding electrode toward the part of the system at ground potential.

According to an example, the first shielding electrode 10 of the at least one shielding electrode is in the vicinity of the first part of the voltage divider and the second shielding electrode 11 of the at least one shielding electrode is in the vicinity of the second part of the voltage divider. Thus, the voltage sensor with a voltage divider can have none, one, or two shielding electrodes.

According to an example, an end of the at least one shielding electrode 24 toward the centre of the voltage divider has a radius of curvature of at least 0.1mm.

According to an example, a length of semiconductor material of the at least one length of semiconductor material is wound around the shielding electrode of the at least one shielding electrode in the vicinity of the first part of the voltage divider. Additionally, or alternatively a length of semiconductor material of the at least one length of semiconductor material is wound around the shielding electrode of the at least one shielding electrode in the vicinity of the second part of the voltage divider.

According to an example, a first length of semiconductor material of the at least one length of semiconductor material is wound around the first shielding electrode and a second length of semiconductor material of the at least one length of semiconductor material is wound around the second shielding electrode.

According to an example, the voltage sensor comprises at least one insulating former 22 surrounding at least one part of the axis. The at least one length of semiconductor material is wound around the at least one former.

According to an example, a former of the at least one former is attached to the shielding electrode of the at least one shielding electrode that is in the vicinity of the first part of the voltage divider. Additionally, or alternatively a former of the at least one former is attached to the shielding electrode of the at least one shielding electrode that is in the vicinity of the second part of the voltage divider.

According to an example, a length of semiconductor of the at least one length of semiconductor is electrically connected to the shielding electrode that is in the vicinity of the first part of the voltage divider. Additionally, or alternatively a length of semiconductor of the at least one length of semiconductor is electrically connected to the shielding electrode that is in the vicinity of the second part of the voltage divider.

According to an example, a first former of the at least one former is in the vicinity of the first part of the voltage divider and a second former of the at least one former is in the vicinity of the second part of the voltage divider.

According to an example, the voltage sensor comprises a first wire 6 and a second wire 7. The first wire is configured to be electrically connected at a point between the high voltage impedance and the low voltage impedance. The second wire is configured to be electrically connected at a point between the low voltage impedance and the part of system at ground potential.

As discussed above, a medium voltage or high voltage switchgear can have one or more voltages measured through having one or more voltage sensors as described above.

Continuing with the figures, specific detailed embodiments will now be described with respect to Figs. 2-5. As shown in Fig. 2, the structure and design of the electric field forming electrodes has been modified in order to decrease the electric field intensity and stress exposed to the resistive voltage divider. A semi-conductive material has been used for field forming electrode in a way, which gradually decreases the electric field intensity over the resistive divider. A semi-conductive tape is fixed and mounted over some former, in a spiral manner with each layer (or turn) of the tape insulated from the other layers (or turns). In this way the electric field is gradually reduced, leading to an associated reduction in electric field stress. The level of conductivity of the tape will influence final electric field stress at the end of the electrode, as well as along the resistive divider, significantly eliminating a risk of breakdown or PD levels over the acceptance limits. Rather than use a semiconductor tape, a semiconductor wire can be used. Also, mention has been made above to a resistive voltage divider benefitting from this modification, however the same can be used for a capacitive voltage divider, depending on its structure and design.

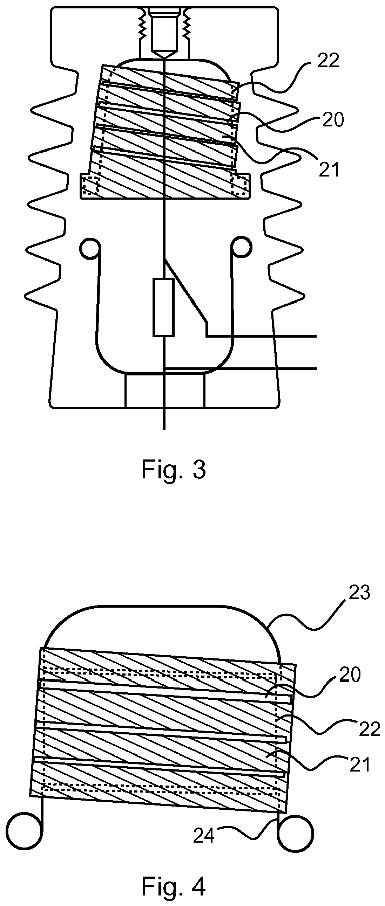

Fig. 3 show the new voltage sensor in more detail. The semi-conductive tape 21 is fixed in a spiral pattern to the former 22. Here, the former can be part of a shielding electrode or can be a separate formed that is attached to the electrode, with this latter example discussed specifically with respect to Fig. 4. Continuing with Fig. 3, the spiral pattern can be either applied to the whole length of the tape 21 or just to a part of the tape, due to production method applied and/or design used. Each "turn" or "wind" of the spiral is insulated from the other "turns" or "winds" by insulating material 20. By applying the tape in this manner, the electric field stress in area highlighted in Fig. 2 as the "areas of highest electric field stress" is significantly reduced, especially when the resistivity of semi-conductive tape is high. This design can be preferably applied on the electrode connected to the medium/high voltage potential, but also on the electrode connected to ground potential or to both of them. The electric stress is then reduced between the electrodes, but also on the surface of divider, which otherwise would cause the voltage sensor to be more sensitive to manufacturing deviations and thus the new design improves product quality.

Fig. 4 is shows another example of a voltage sensor having an electric stress reducing electrode. This design of the electric stress reducing electrode consist of more parts than that described above. First, the rigid electrode 23 in the form of a cap or ring is used to connect to the medium or high voltage potential. The electrode 23 is made of electrically conductive or semi-conductive material. The electrode 23 is then mechanically fixed to the former 22 on which the semi-conductive tape 21 in a spiral pattern is applied and electrically interconnected with the rigid electrode 23 on one end of the tape (21). That structure is then connected to another rigid electrode 24 in the form of a ring, mechanically fixed to the former 22 and electrically connected to the semi-conductive tape 21. The radius created on one side of the electrode 24 beneficially reduces an electric stress in surrounding area, and is at least 0.1mm. The voltage divider construction shown in Fig.4 can be easier for final manufacturing and assembly of the stress reducing electrode compared with the construction described in Fig.3. The design shown in Fig. 3 can however provide a larger reduction of electric stress than the design shown in Fig. 4.

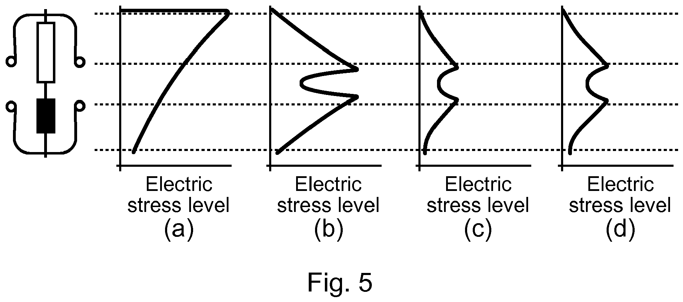

Regarding, the reduction in electric field stress, this is shown in Fig. 5. Fig. 5 shows examples of the electric field stress distribution along the voltage divider. In Fig, 5a, the electric stress level is shown along a voltage divider of a voltage sensor that does not have any shielding electrodes. In Fig, 5b, the electric stress level is shown along a voltage divider of a voltage sensor shown in Fig.1. In Fig, 5c, the electric stress level is shown along a voltage divider of a voltage sensor shown in Fig.3, where the new design of stress reduction is used on both parts of the divider. In Fig, 5d, the electric stress level is shown for a voltage sensor along a voltage divider having a stress reducing electrode as shown in Fig.4, where the new design of stress reduction is used on both parts of the divider.

While the invention has been illustrated and described in detail in the drawings and foregoing description, such illustration and description are to be considered illustrative or exemplary and not restrictive. The invention is not limited to the disclosed embodiments. Other variations to the disclosed embodiments can be understood and effected by those skilled in the art in practicing a claimed invention, from a study of the drawings, the disclosure, and the dependent claims.

## Claims

1. A voltage sensor for medium voltage or high voltage measurements, the voltage sensor comprising:
- a high voltage impedance (3);
- a low voltage impedance (5); and
- at least one part comprising semiconductor material;
wherein, the high voltage impedance is configured to be electrically connected to a part of a system at high voltage potential, wherein the high voltage impedance forms a first part of a voltage divider;
wherein, the low voltage impedance is configured to be electrically connected to part of a system at ground potential, wherein the low voltage impedance forms a second part of the voltage divider;
wherein, the high voltage impedance is electrically connected to the low voltage impedance such that an axis is defined extending through the high voltage impedance and the low voltage impedance; and
wherein, the at least one part comprising semiconductor material surrounds at least one part of the axis.

2. Voltage sensor according to claim 1, wherein the at least one part comprising semiconductor material is configured to gradually reduce electric field stress in at least one direction along the axis toward the centre of the voltage divider.

3. Voltage sensor according to any of claims 1-2, wherein the at least one part comprising semiconductor material comprises at least one length of semiconductor material (21), wherein the at least one length of semiconductor material is wound around and spaced from the at least one part of the axis, and wherein at least a part of the at least one length of semiconductor material is wound in a spiral form extending along the axis.

4. Voltage sensor according to claim 3, wherein a length of the at least one length of semiconductor material is wound around and spaced from a part of the axis in the vicinity of the first part of the voltage divider and/or a length of the at least one length of semiconductor material is wound around and spaced from a part of the axis in the vicinity of the second part of the voltage divider.

5. Voltage sensor according to claim 4, wherein a first length of the at least one length of semiconductor material is wound around and spaced from the axis in the vicinity of the first part of the voltage divider and a second length of the at least one length of semiconductor material is wound around and spaced from the axis in the vicinity of the second part of the voltage divider.

6. Voltage sensor according to any of claims 3-5, wherein at least one turn of the at least one length of semiconductor material is spaced from at least one adjacent turn of the at least one length of semiconductor material.

7. Voltage sensor according to any of claims 3-6, wherein at least one turn of the at least one length of semiconductor material is spaced from and insulated from at least one adjacent turn of the at least one length of semiconductor material by an insulating material (20).

8. Voltage sensor according to any of claims 3-7, wherein the at least one length of semiconductor material has a resistivity of at least 10 Ohm per metre.

9. Voltage sensor according to any of claims 3-8, wherein the at least one length of semiconductor material is a semiconductor tape or semiconductor wire

10. Voltage sensor according to any of claims 1-8, wherein the voltage sensor comprises at least one shielding electrode (10, 11) surrounding at least one part of the axis.

11. Voltage sensor according to claim 10, wherein a shielding electrode (10) of the at least one shielding electrode is in the vicinity of the first part of the voltage divider and/or a shielding electrode (11) of the at least one shielding electrode is in the vicinity of the second part of the voltage divider.

12. Voltage sensor according to any of claims 10-11, wherein the shielding electrode (10) of the at least one shielding electrode in the vicinity of the first part of the voltage divider comprises a part of the shielding electrode configured to be at high voltage potential and the shielding electrode comprises an axial dimension toward the centre of the voltage divider that is greater than an axial dimension of the shielding electrode toward the part of the system at high potential and/or the shielding electrode (11) of the at least one shielding electrode in the vicinity of the second part of the voltage divider comprises a part of the shielding electrode configured to be at ground potential and the shielding electrode comprises an axial dimension toward the centre of the voltage divider that is greater than an axial dimension of the shielding electrode toward the part of the system at ground potential.

13. Voltage sensor according to any of claims 10-12, wherein a first shielding electrode (10) of the at least one shielding electrode is in the vicinity of the first part of the voltage divider and a second shielding electrode (11) of the at least one shielding electrode is in the vicinity of the second part of the voltage divider.

14. Voltage sensor according to any of claims 10-13, wherein an end of the at least one shielding electrode (24) toward the centre of the voltage divider has a radius of curvature of at least 0.1mm.

15. Voltage sensor according to any of claims 11-14 when dependent upon any of claims 3-9, wherein a length of semiconductor material of the at least one length of semiconductor material is wound around the shielding electrode of the at least one shielding electrode in the vicinity of the first part of the voltage divider and/or a length of semiconductor material of the at least one length of semiconductor material is wound around the shielding electrode of the at least one shielding electrode in the vicinity of the second part of the voltage divider.

16. Voltage sensor according to claim 15, wherein a first length of semiconductor material of the at least one length of semiconductor material is wound around the first shielding electrode and a second length of semiconductor material of the at least one length of semiconductor material is wound around the second shielding electrode.

17. Voltage sensor according to any of claims 3-14, wherein the voltage sensor comprises at least one insulating former (22) surrounding at least one part of the axis, and wherein the at least one length of semiconductor material is wound around the at least one former.

18. Voltage sensor according to claim 17 when dependent upon any of claims 11-14, wherein a former of the at least one former is attached to the shielding electrode of the at least one shielding electrode that is in the vicinity of the first part of the voltage divider and/or a former of the at least one former is attached to the shielding electrode of the at least one shielding electrode that is in the vicinity of the second part of the voltage divider.

19. Voltage sensor according to claim 18, wherein a length of semiconductor of the at least one length of semiconductor is electrically connected to the shielding electrode that is in the vicinity of the first part of the voltage divider and/or a length of semiconductor of the at least one length of semiconductor is electrically connected to the shielding electrode that is in the vicinity of the second part of the voltage divider.

20. Voltage divider according to any of claims 17-19, wherein a first former of the at least one former is in the vicinity of the first part of the voltage divider and a second former of the at least one former is in the vicinity of the second part of the voltage divider.

21. Voltage sensor according to any of claims 1-20, wherein the voltage sensor comprises a first wire (6) and a second wire (7), wherein the first wire is configured to be electrically connected at a point between the high voltage impedance and the low voltage impedance, and wherein the second wire is configured to be electrically connected at a point between the low voltage impedance and the part of system at ground potential.

22. A medium voltage or high voltage switchgear, comprising at least one voltage sensor according to any of claims 1-21.
